# EUROPEAN PATENT SPECIFICATION

(11) **EP 2 655 699 B1**
(45) Date of publication and mention of the grant of the patent: **26.06.2019**
(21) Application number: 10795402.6
(22) Date of filing: 23.12.2010
(51) Int. Cl.: C25D 7/12, H01L 21/288, H05K 3/20

(54) **AN ECPR MASTER ELECTRODE, AND A METHOD FOR PROVIDING SUCH MASTER ELECTRODE**
ECPR-MASTERELEKTRODE UND VERFAHREN ZUR BEREITSTELLUNG SOLCH EINER MASTERELEKTRODE
ÉLECTRODE-MAÎTRE DE TYPE ECPR (RÉPLICATION ÉLECTROCHIMIQUE DES MOTIFS) ET PROCÉDÉ POUR OBTENIR UNE TELLE ÉLECTRODE-MAÎTRE

(43) Date of publication of application: 30.10.2013
(73) Proprietor: Luxembourg Institute of Science and Technology (LIST), 4362 Esch-sur-Alzette (LU)
(72) Inventor: CUTHBERTSON, Alan, 38320 Herbeys (FR); MÖLLER, Patrik, 112 52 Stockholm (SE); FREDENBERG, Mikael, 112 34 Stockholm (SE); VAN DEN HOEK, Wilbert, Saratoga, CA 95070 (US)
(74) Representative: Lecomte & Partners
(86) International application number: PCT/EP2010/070645
(87) International publication number: WO 2012/084046

(56) References cited:
- WO-A1-02/103085
- JP-A- 2005 256 110
- US-A1- 2005 077 630
- US-A1- 2009 229 855

## Description

### TECHNICAL FIELD

The present invention relates to the process of electrochemical pattern replication. More particularly, the present invention relates to a master electrode for use in such processes as well as to a method for manufacturing such master electrode.

### BACKGROUND ART

WO 02/103085 relates to an electrochemical pattern replication method, ECPR, and a construction of a conductive master electrode for production of appliances involving micro and nano structures. An etching or plating pattern, which is defined by a master electrode, is replicated on an electrically conductive material, a substrate. The master electrode is put in close contact with the substrate and the etching/plating pattern is directly transferred onto the substrate by using a contact etching/plating process. The contact etching/plating process is performed in local etching/plating cells, which are formed in cavities between the master electrode and the substrate.

The master electrode is used for cooperation with a substrate, onto which a structure is to be built. The master electrode then forms at least one, normally a plurality of electrochemical cells in which etching or plating take place.

The master electrode may be made of a carrier element of a durable material, since the master electrode should be used for a plurality of processes of etching or plating. One such material is Si, which allows the master electrode to be manufactured by well established and high yield semiconductor processes. The master electrode has a conductive back side and a front side, i.e. the side of the master electrode facing the substrate, comprises a plurality of electrochemical cells, each cell being defined by an electrically insulating pattern layer. The bottom of each electrochemical cell comprises an electrically conductive material being conductively connected to the back side of the master electrode. Further, the front side of the carrier element is provided with an insulating layer for preventing plating current to flow between the electrochemical cells.

During the manufacturing of such master electrode, a number of different defects may be formed on the carrier element. This includes for example, surface or embedded particles or physical damage (eg. microscratches) being present on the front side of the carrier element during manufacturing. Such defects may form a pinhole in the insulating layer or result in unwanted masking during the etch processes used to create the cavities in the carrier element.

Before the master electrode is used in the ECPR, the electrochemical cells need to be prefilled with a conductive material, if material is to be plated onto the substrate. Usually, the thickness of the prefilled material is in the range of 0.5 to 5 micrometers, depending on the specific application. During the ECPR the conductive material is then transferred from the bottom of the electrochemical cells of the master electrode to the substrate being plated.

If there is a disruption in the insulating layer, the prefilling may result in deposition of the prefill material on the defect where a parasistic current path is present through the defect to the bulk of the carrier element. The prefill deposits on the defects can result in parasitic electrical leakage current between the master electrode and the substrate during ECPR transfer and may also act as a physical barrier to the two being brought into close proximity resulting in poor ECPR pattern replication. Parasitic leakage currents will detract from the intentional ECPR transfer current in the cavities causing the pattern to be thinner than intended in the region surrounding the defect. In extreme cases where the parasitic current is high relative to the ECPR plating current no pattern will be transferred in the region of the defect. Such defects may adversely affect the yield or reliability of the circuit being produced using ECPR. Thus, there is a need for ensuring that the master electrode is insensitive for such defects, or at least reducing the possible impact of such defects during an ECPR process.

An example of an electrode is disclosed in US 2009/229855 A1.

### SUMMARY OF THE INVENTION

An object of the present invention is to provide an electrode in which the above-mentioned problems are at least partly eliminated or alleviated.

Another object is to provide a master electrode that can be used for several processes of etching or plating.

A further object is to provide a master electrode having a reduced sensitivity for defects. An idea of the present invention is to provide a master electrode that has an intrinsic capability of allowing and blocking current to flow through the master electrode during the ECPR process.

According to an aspect of the invention an ECPR master electrode according to claim 1 is provided.

The master electrode may be manufactured by readily available semiconducting carrier elements, such as Si wafers, for allowing high yield processes and facilitated manufacturing.

Said at least one electrochemical cell extends through said structure, and said structure is -arranged at the front side of said carrier element and may extend in a direction towards the electrode surface on the back side, wherein the thickness of the current blocking structure is less than the depth of the at least one electrochemical cell. Hence, the structure will still allow a low resistance current path between the electrode surface on the backside of said carrier element and the conductive bottom of the electrochemical cells.

Said structure comprises an epitaxial layer forming an increase of the resistance of said carrier element. Said structure may be a p- epitaxial layer or preferably an intrinsic epitaxial layer Hence, the structure may be provided using standard semiconducting processes such that high yield and cost effectiveness is achieved.

Said structure may comprise a p-n junction which may be reverse biased during either prefill or ECPR transfer depending on the polarity of the junction used (p-n or n- p). This is advantageous in that the resistance characteristics of said structure may be designed in a very controlled manner for preventing parasitic currents.

Said structure may comprise a bipolar transistor, wherein at least one p-n junction of said bipolar transistor is reverse biased during use, and said bipolar transistor may be a p-n-p transistor. This is advantageous in that the resistance characteristics of said structure may be designed in a very controlled manner for preventing parasitic currents not only during the plating process, but also during the prefill process.

Said structure may comprise an insulating layer such that said carrier element is forming a silicon on insulator substrate. Hence, also in this case the structure may be provided using standard semiconducting processes such that high yield and cost effectiveness is achieved.

According to a second aspect of the invention, a method for providing an ECPR master electrode is provided with the features of claim 10.

The step of providing an electrical current preventing or obstructing structure between said front side and said back side of said carrier element may comprise building a bipolar transistor on said carrier element.

The step of providing an electrical current preventing or obstructing structure between said front side and said back side of said carrier element may comprise building a silicon-on-insulator structure on said carrier element.

The advantages of the first aspect of the invention are also applicable for the second aspect of the invention.

### BRIEF DESCRIPTION OF DRAWINGS

Further objects, features and advantages of the invention will appear from the following detailed description of several embodiments with reference to the drawings, in which:
Fig. 1(a) and (b) are schematic cross-sectional views of a master electrode according to prior art;
Figs. 2a and 2b are schematic cross-sectional views of a master electrode having defects;
Fig. 3 is a schematic cross-sectional view of a master electrode according to an embodiment of the present invention;
Fig. 4 is a schematic cross-sectional view of a master electrode according to a further embodiment;
Fig. 5a is a schematic cross-sectional view of a master electrode according to another embodiment; and
Fig. 5b is a schematic cross-sectional view of the master electrode shown in Fig. 5a including electrical circuit details.

### DETAILED DESCRIPTION OF EMBODIMENTS

Below, several embodiments of the invention will be described with references to the drawings. These embodiments are described in illustrating purpose in order to enable a skilled person to carry out the invention and to disclose the best mode.

However, such embodiments do not limit the invention, but other combinations of the different features are possible within the scope of the invention.

Some general remarks are given below with regard to the master electrode and methods of forming the master electrode. Several methods are described for forming a master electrode that can be used for producing one or multiple layers of structures of
one or multiple materials including using an electrochemical pattern replication (ECPR) technology described below. The methods generally include: forming a master electrode that comprises a carrier element which is conducting and/or semiconducting in at least some parts; forming a conducting electrode layer which functions as anode in ECPR plating and cathode in ECPR etching on a front side of the master electrode; and forming an insulating pattern layer that defines the cavities in which ECPR etching or plating can occur in the ECPR process on said front side, such that conducting electrode layer(s) is/are obtained in the bottom of the cavities; in a way that makes possible electrical contact from an external power supply to the back side of the master electrode for allowing electron transfer through the master electrode to the front side thereof to the conducing electrode surface(s), such that said surface(s) will constitute anode(s) in ECPR plating and cathode(s) in ECPR etching.

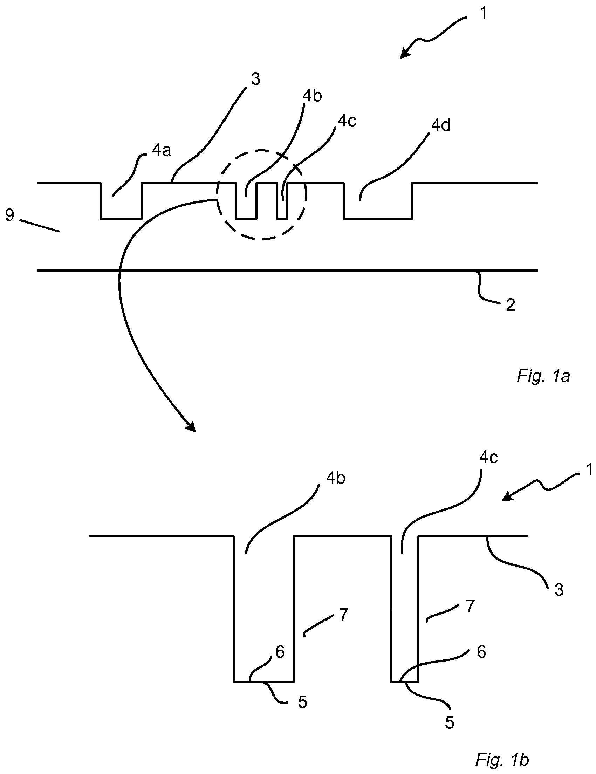

With reference to Figs. 1(a) and 1(b), schematic cross-sectional views of a prior art master electrode 1 are shown. The master electrode 1 is formed of a carrier element 9 having a back side being at least partly covered by an electrically conductive material for forming an electrode surface 2. The front side of the carrier element 9, i.e. the side facing the substrate to be replicated during an ECPR process, has a topographic surface 3 defining the pattern to be replicated by said master electrode 1. The topographic surface 3 has a plurality of cells 4a, 4b, 4c, etc., which are used as electroplating cells during the ECPR process. The bottom 5 of each cell 4a, 4b, 4c, etc. comprises an electrically conducting surface 6. An insulating layer is formed at the front side 3 of the carrier element 9 between the electrochemical cells 4a - 4d for preventing plating to occur on the substrate at positions being aligned with the insulating layer.

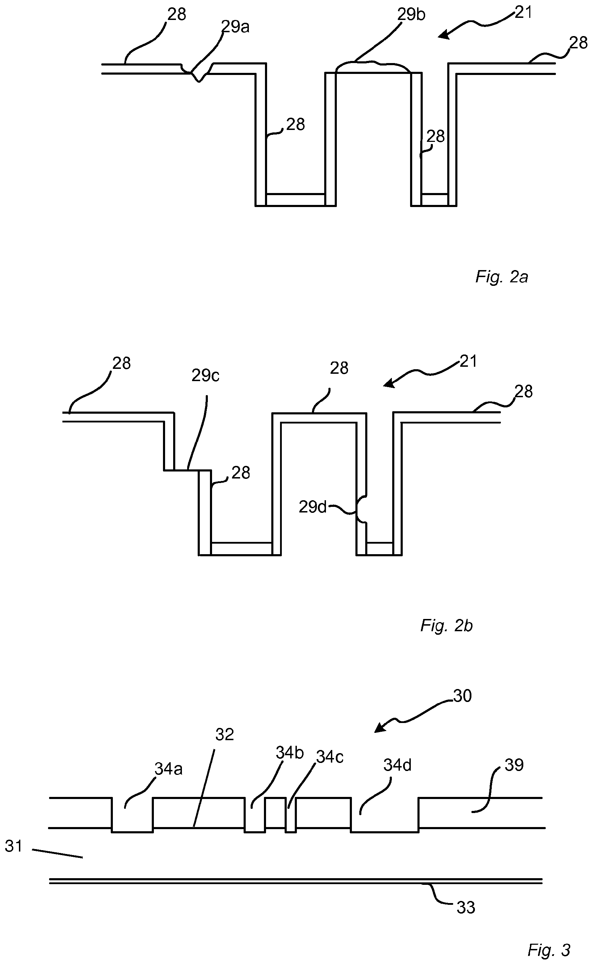

With reference to Fig. 2, an example of a part of a master electrode 21, according to one embodiment of the present invention, is shown. A layer of an electrically insulating material 28 is arranged on the front side of the master electrode 21, to be in physical contact with the substrate during ECPR, or at least in close adjacency of the substrate during ECPR. A plurality cavities are arranged on said front side, the side walls of said cavities also having the electrically insulating material arranged thereon, such that only the bottom of said cavities are intended to be electrically conductive and conductively connected to the backside of the master electrode 21 during prefill or during ECPR. This embodiment is illustrated with defected insulating material 28. The insulating material 28 is disruptive at two different positions 29a and 29b. At 29a, a scratch or similar has caused the insulating material 28, as well as the upper surface of the underlying substrate to be damaged and deformed. Due to the lack of insulating material at 29a and 29b, these areas may be unintentionally filled up with conducting electrode layer during the master manufacturing, which would normally only be deposited in the bottom of the masters cavities.

Before any plating may be performed during the ECPR process, the electrochemical cells of the master electrode are pre-filled with a bulk of conductive material, such as copper. This process, generally known as a pre-fill process, is performed by an electrochemical plating of a transfer conductive material at the bottom of each one of the electrochemical cells. When positioned in a plating chamber, the master electrode is connected to a voltage source allowing ions to be plated at the bottom of the electrochemical cells through an electrolyte in the electrochemical cells. Thus a bulk material at each bottom will be formed. Hence, when the master electrode 21 is positioned within a plating chamber, electrolytic solution is allowed to fill the space at 29a thus leading to a possible risk of unwanted plating current of the master at a position facing the defect 29a. The material deposited (either electrode layer material, pre-filled material or both) at 29a would create a short circuit between the master and a substrate, when they are placed in close contact with each other in the subsequent ECPR process, and an unwanted parasitic current would then pass which could significantly reduce the transfer rate of the ECPR process in the neighboring electrochemical cells - leading to very non-uniform thickness of the transferred material, unless the master electrode comprised features according to embodiments disclosed below.

At 29b, a defect has formed a micro mask prior to the trench etching process, and there is consequently no insulating material 28 covering the area between the two adjacent electrochemical cells. During the ECPR process, parasitic currents would thus be able to flow from the master electrode to the substrate via the defect at 29b, unless the master electrode comprised features according to embodiments disclosed below.

Defects can also be present on the sidewalls, as disclosed in Fig. 2b. In Fig. 2b sidewall defects 29c and 29d are disclosed. Sidewall defect 29c may be obtained if the forming of the cavity for some reason is obstructed, and the side wall becomes "stepped". Later application of the layer of insulating material 28 may then risk to only cover vertical surfaces, depending on application method. Thus, a plateau is formed which may be of a conducting or semiconducting material, depending on which carrier is used. During the ECPR process, parasitic currents would thus be able to flow from the master electrode to the substrate via the defect at 29b, unless the master electrode comprised features according to embodiments disclosed below. In the sidewall defect 29d, the application of the layer of electrically insulating material has failed, and a hole or crater has been formed, through which the same kind of parasitic currents would be able to flow, in accordance with above.

Turning to Fig. 3, a master electrode 30 according to an embodiment is shown. The master electrode 30 is formed by a carrier element 31 having a back side being provided with an electrode surface 33. The electrode surface 33 may be an electrode layer. The master electrode 30 further comprises a front side 32. The carrier element 31 comprises a conductive and/or semi conductive material, such that electrical current may flow from the electrode surface 33 to the front side 32 and into a substrate (not shown) arranged in close contact with the front side of the master electrode 30, through an electrolyte between the master electrode 30 and the substrate, and also electrical current in the opposite direction. The carrier element 31 may be a disc shape element (such as a wafer) of said conductive or semi conductive material. The front side 32 comprises a plurality of electroplating cells 34a, 34b, 34c, etc. The electroplating cells 34a, 34b, 34c, etc. are formed as a topographical pattern on the front side 32. The bottoms of the electroplating cells 34a - 34d comprise an electrode surface. The electrode surface may be formed on an electrode layer, applied in the bottom of the electroplating cells 34a - 34d. The electrode surfaces in the bottom of the electroplating cells 34a - 34d are conductively connected to the electrode surface 33 on the back side of the master electrode 30. The top surface of the front side 32, i.e. the top surface of the topographical pattern, is electrically insulating by means of the provision of an electrically insulating layer. In the same way, the sidewalls of the electroplating cells 34a-34d are also provided with an electrically insulating layer arranged thereon, such that only the bottom of said cavities are intended to be electrically conductive and conductively connected to the backside of the master electrode 30 during prefill or during ECPR. The electrolyte will then be arranged in the electroplating cells 34a, 34b, 34c, etc. The carrier element may e.g. be formed by a 6, 8, or 12 inch Si wafer, depending on the size of the substrates to be plated by the ECPR process. Other semiconducting materials may also be chosen as the basic material structure of the master electrode 30, like for example III-V materials commonly used within the semiconductor industry.

The carrier element 31 of the master electrode 30 comprises a structure 39 which is arranged to obstruct or prevent current during a voltage between the electrode surface 33 and the front side 32 of the master electrode 30, and vice versa. The structure 39 may thus be a current suppression or current blocking structure. The structure 39 may also be a separate structure, such as layer, arranged on top of the carrier element 31, when the front side of the master electrode 30 is facing upwards. In this respect, the structure 39 is arranged to form resistance, such as a high series resistance, between the electrode layer 33, when the back side of the master electrode 30 is provided with a separate electrode layer 33, and the front side 32, i.e. the top surface of the master electrode 30 being in contact with a seed layer of the substrate during plating by the ECPR process. When the carrier element 31 is doped at a relatively high rate, for example p+, it is considered as a fairly good conductor. The structure 39 may comprise a layer in an upper zone of the carrier element 31 or on top of the carrier element 31 of the master electrode reducing the conductivity of the master electrode 30. In Fig. 3, the structure 39 is formed as a layer having a much lower doping level, thus forming the increased resistance of the master electrode 30. The structure 39 in Fig. 3 may then be a Si layer having lower, such as substantially lower, conductivity than the carrier element 31 beneath the structure 39. The structure 39 may be formed either as an intrinsic epitaxial layer, or as lightly doped epitaxial layer. The intrinsic epitaxial layer may be undoped. In the case of a silicon substrate, the carrier element 31 may have a doping level in the range 10¹⁷ to 10¹⁹ atoms/cm3. To achieve the immunity to defects, the doping level of the structure 39 may then be in the range of 10¹³ to 10¹⁷ atoms/cm³. When the carrier element 31 is comprising a p-type semiconductor typical doping atoms used include boron, indium and gallium whilst in the case of an n-type doped carrier element typical doping atoms could include arsenic, phosphorus and antimony. Typical dopants used in the epitaxial layer include boron, arsenic and phosphorus.

The thickness of the structure 39, which structure extends from the upper-most part of the carrier element 31 or on top of the carrier element 31, in between the insulating surface on the front side of the master electrode 30 and downwards towards the electrode surface in the bottom of the electrochemical cells, is preferably less than the depth of the electrochemical cells 34a - 34d formed at the front side 32 of the master electrode 30. In this way the structure 39 will extend between the electrochemical cells 34a - 34d, such that the increased resistance is obtained above the bottom of the electrochemical cells 34a - 34d when the front side 32 thereof is facing upwards. This is advantageous in that the structure 39 does not affect the conducting properties of the parts of the master electrode 30 being provided at the bottom of the electrochemical cells. That is, during manufacturing of the master electrode 30 the deep trench etch is preferably provided completely through the structure 39.

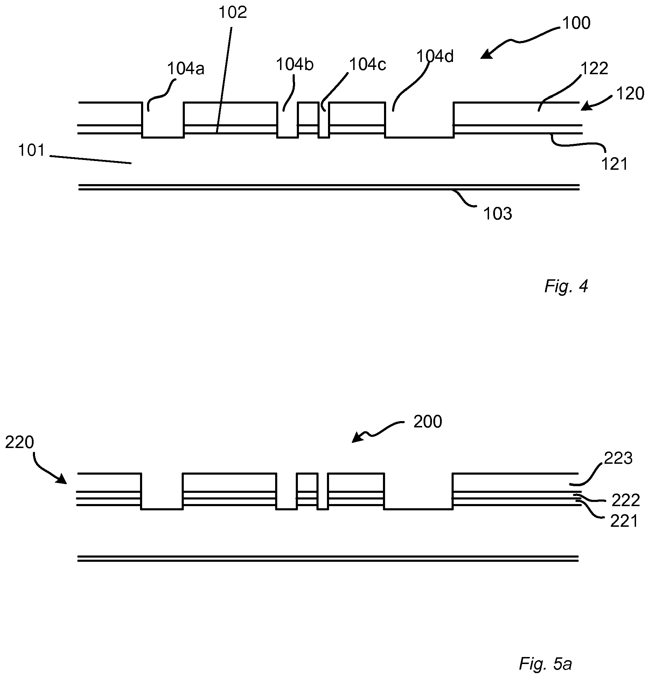

The structure 39 may also comprise a layer in an upper zone of the carrier element 31 or on top of the carrier element 31 of the master electrode which is the opposite doping type to the carrier element. The structure 39 in Fig. 3 may then be a Si layer which is doped n-type in the case of a p+ carrier element. The layer 39 may also be p-type in the case of a n+ doped carrier element. To achieve the immunity to defects, the doping level of the structure 39 may then be in the range of 10¹³ to 10¹⁷ atoms/cm³. When the carrier element 31 is comprising a p-type semiconductor typical doping atoms used include boron, indium and gallium whilst in the case of an n-type doped carrier element typical doping atoms could include arsenic, phosphorus and antimony. Typical dopants used in the epitaxial layer include boron, arsenic and phosphorus. The use of ion implantation and furnace annealing also provide an alternative method of forming the desired structure. In this case typical dopants used include boron, arsenic and phosphorus. With reference to Fig. 4, another embodiment of a master electrode 100 will be described. The master electrode 100 is formed by a carrier element 101 having a back side having being provided with an electrode surface 103, such as an electrode layer, and a front side 102 comprising a plurality of electroplating cells 104a, 104b, 104c, etc, formed as a topographical pattern on the front side 102, with electrode surfaces in the bottoms thereof. The top surface of the topographical pattern is electrically insulating.

The carrier element 101 of the master electrode 100 comprises a structure 120 which is arranged to obstruct or prevent electrical current from passing from the electrode surface 103 of the back side to the front side 102 of the master electrode, in accordance with the structure 39 in the embodiment according to Fig. 3. The structure 120 is thus arranged to form resistance, such as a high series resistance, between the electrode layer 103 on the back side and the front side 102 of the carrier element 101, i.e. the electrically insulating top surface of the master electrode 100 being in contact with a seed layer of the copy substrate during plating. When the Si substrate is doped at a relatively high rate, for example p+, it is considered as a fairly good conductor. The structure 120 comprises a silicon-on-insulator at the most upper part of the carrier element 101 of the master electrode, reducing the conductivity of the master electrode 100. In Fig. 4, the structure 120 is formed as an insulating layer 121, e.g. SiO₂. The insulating layer 121 may be combined with an epitaxial layer 122 of low doped Si grown on top of the insulating layer 121.

The thickness of the structure 120, which structure extends from the upper-most part of the Si carrier element 101 of the master electrode 100 and downwards towards the electrode layer 103, is preferably less than the depth of the electrochemical cells 104a - 104d formed at the front side 102 of the master electrode 100. The advantages of the master electrode 100 described with reference to Fig. 3 apply also for the embodiment shown in Fig. 4.

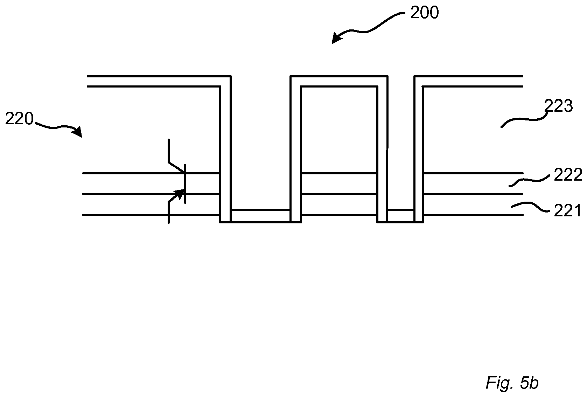

A yet further embodiment of a master electrode is shown in Fig. 5a and 5b. Here, the master electrode 200 has a similar construction as the master electrodes shown in Fig. 3 and Fig. 4. In this embodiment, the structure 220 is formed such that a vertical bipolar junction transistor is present in the upper part of the carrier element 200. The structure 220 is having either a p-n-p or n-p-n junction arrangement. In the case of the p-n-p arrangement, the Si carrier element 201 is typically p+ doped with a grown epitaxial layer 221 of p- doped material. On said p- material, a further layer 222 of an n+ doped material is grown, and finally a layer 223 of p- doped material is grown on top of the intermediate n+ layer 222. The layers 221, 222 and 223 can be formed using a variety of processes including but not limited to CVD epitaxial deposition with alternating dopant sources and ion implantation in conjunction with epitaxial layer deposition.

Thicknesses of the buried layer can be adjusted according to the depth of the cavities in the master being less than a micron to several microns. The doping profile of the buried layer depends upon the process used to create the layers 221, 222, 223. Typical layer thicknesses may be from 1 to several microns.

The thickness of the structure 220, which structure extends from the upper-most part of the Si carrier element 201 of the master electrode 200 and downwards towards the electrode layer 203, is also in this case preferably less than the depth of the electrochemical cells formed at the front side of the master electrode 200. This is advantageous in that the structure 220 does not affect the conducting properties of the parts of the carrier element 201 being provided with the electrochemical cells. That is, during manufacturing of the master electrode 200 the deep trench etch of the carrier element 201 is provided completely through the structure 220.

The front side of the master electrode 200 is shown in further details in Fig. 5b. The doping type of the layer 222 is opposite polarity to the surrounding layers 221 and 223 such that a vertical junction transistor is formed with the layer 222 and base of the transistor. The emitter and collector regions of the transistor are reversible depending upon the mode of operation. Back to back diodes are created in this structure 220 at the junction of the materials 221 to 222 and 223 to 222. Junction diodes when reverse biased by an external voltage source are highly effective at blocking current flow. Before any plating may be performed, the electrochemical cells of the master electrode 200 are pre-filled with a bulk of conductive material, such as copper. This process, generally known as a pre-fill process, is performed by an electrochemical plating of a transfer conductive material at the bottom of each one of the electrochemical cells. When positioned in a plating chamber, the master electrode is connected to a voltage source allowing ions to be plated at the bottom of the electrochemical cells through an electrolyte in the electrochemical cells. Thus a bulk material at each bottom will be formed. This means that the bottom p-n junction, i.e. the junction formed between the player 221 and the n+ layer 222 is reverse biased and hence current is prevented to flow through the bottom p-n junction.

After the pre-fill process, the master electrode 200 is used for transferring the bulk material grown at the bottom of each electrochemical cell to a seed layer of a substrate arranged in close contact with the front side of the master electrode 200 during an ECPR process. In this process, the master electrode is again connected to a voltage source for allowing ions to flow from the bulk material of the electrochemical cells to the substrate to be plated. In this mode, the upper p-n junction, i.e. the junction formed between the n+ layer 222 and the upper p- layer 223 will be reversed biased and hence current is prevented to flow through the upper p-n junction.

The structure 220 will block parasitic currents as long as the voltage being applied to the master electrode 200 is much less than the BVCEO (breakdown voltage collector-to-emitter with base open) of the p-n-p or n-p-n transistor. It is thus preferred to provide the base layer with a relative high doping level in order to suppress upward gain and to avoid punch-through caused by the upper and lower depletion regions meeting in the layer 222.

For a master electrode according to any of the previously described embodiments, the depth of each electrochemical cell may be in the range of 1 to 100 microns, such as between 2 and 20 microns. The lateral dimensions of each cell is being dependent on the pattern to be replicated, but may range from sub-micron and upwards.

In a typical example, the depth of an electrochemical is 15 microns. Consequently, the thickness of the structure for preventing the parasitic currents due to defects on the master electrode is less than 15 micrometers.

In all the embodiments disclosed in Figs. 2 to 5, and the corresponding passages above, the sidewalls of the electroplating cells and the top surface intended to face the substrate to plated/etched in ECPR, are also provided with an electrically insulating layer arranged thereon, such that only the bottom of said cavities are intended to be electrically conductive and conductively connected to the backside of the master electrode 21, 30, 100, 200 during prefill or during ECPR.

It is readily understood that all references to lower/upper are merely for illustrative purposes, without any limiting effect on the scope of protection. Moreover, it should be realized that equivalent setups to those described may include setups having a substrate arranged on a lower chuck while the master electrode is mounted on an upper chuck, as well as setups in which the positions of the lower and upper chuck are switched.

In the claims, the term "comprises/comprising" does not exclude the presence of other elements or steps. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. An electrochemical pattern replication (ECPR) master electrode (30, 100, 200), comprising a carrier element (31, 101, 201) comprising a doped semiconducting material, the master electrode having an electrically conducting electrode surface (33, 103, 203) on a back side and a topographical pattern on a front side (32, 102, 202) with an at least partly electrically insulating top, said topographical pattern is forming at least one electrochemical cell (34a-d, 104a-d, 204a-d) comprising a bottom and at least one side wall, said bottom having an electrically conducting surface being conductively connected to the electrically conducting electrode surface (33, 103, 203) on the back side through the carrier element (31, 101, 201), wherein said carrier element (31, 101, 201) further comprises an electrical current preventing or obstructing structure (39, 120, 220), wherein said electrochemical cell extends through said structure and **characterized in that** said structure (39, 220) comprises an epitaxial layer comprising a semiconducting material that has a lower doping level than the doped semiconducting material of the carrier element or a semiconducting material that comprises layers having an opposite polarity doping type thereby forming a p-n or n-p junction.

2. The master electrode according to claim 1, wherein said structure (39, 120, 220) is arranged at the front side (32, 102, 202) of said carrier element (31, 101, 201) and extends in a direction towards the electrode surface (33, 103, 203) on the back side, wherein the thickness of the structure (39, 120, 220) is less than the depth of the at least one electrochemical cell (34a-d, 104a-d, 204a-d).

3. The master electrode according to claim 1 or 2, wherein said structure (39) is an intrinsic epitaxial layer.

4. The master electrode according to any of claims 1 to 3, wherein said structure (39) is a p-epitaxial layer.

5. The master electrode according to claim 4, wherein the p-epitaxial layer has a doping level in the range 10¹³ to 10¹⁷ atoms/cm³.

6. The master electrode according to any one of claims 1 to 5, wherein said structure (220) comprises a bipolar transistor, comprising at least one p-n junction.

7. The master electrode according to any one of claims 1 to 5, wherein said structure (220) comprises a bipolar transistor, comprising at least one n-p junction.

8. The master electrode according to claim 6 or 7, wherein said bipolar transistor is a p-n-p transistor or n-p-n transistor.

9. The master electrode according to any one of claims 1 to 8, wherein said structure (120) comprises an insulating layer (121) such that said carrier element (101) is forming a silicon on insulator substrate.

10. A method for providing an electrochemical pattern replication (ECPR) master electrode, comprising the step of: providing a carrier element comprising a doped semiconducting material, providing an electrically conducting electrode surface on a back side of the carrier element and a topographical pattern on a front side of the carrier element with at least partly electrically insulating top, such that said topographical pattern is forming at least one electrochemical cell comprising a bottom and at least one side wall, said bottom having an electrically conducting surface, conductively connected to the electrically conducting electrode surface on the back side through the carrier element, wherein said method further comprises the step of: providing an electrical current preventing or obstructing structure wherein said electrochemical cell extends through said structure, **characterized in that** said structure comprises an epitaxial layer comprising a semiconducting material that has a lower doping level than the doped semiconducting material of the carrier element or a semiconducting material that comprises layers having an opposite polarity doping type thereby forming a p-n or n-p junction.

11. The method according to claim 10, wherein the step of providing an electrical current preventing or obstructing structure between said front side and said back side of said carrier element comprises building a bipolar transistor on said carrier element.

12. The method according to claim 10, wherein the step of providing an electrical current preventing or obstructing structure between said front side and said back side of said carrier element comprises building a silicon-on- insulator structure on said carrier element.

## Patentansprüche

1. Eine Masterelektrode (30, 100, 200) zur elektrochemischen Musterreplikation (ECPR), umfassend ein Trägerelement (31, 101, 201) umfassend ein dotiertes halbleitendes Material, wobei die Masterelektrode eine elektrisch leitfähige Elektrodenoberfläche (33, 103, 203) auf einer Rückseite und ein topografisches Muster auf einer Vorderseite (32, 102, 202) mit einer zumindest teilweise elektrisch isolierenden Oberseite hat, wobei das besagte topografische Muster zumindest eine elektrochemische Zelle (34a-d, 104a-d, 204a-d) ausbildet umfassend einen Boden und zumindest eine Seitenwand, wobei der besagte Boden eine elektrisch leitfähige Oberfläche hat, die leitfähig mit der elektrisch leitfähigen Elektrodenoberfläche (33, 103, 203) auf der Rückseite durch das Trägerelement (31, 101,201) verbunden ist, wobei das besagte Trägerelement (31, 101, 201) weiter eine einen elektrischen Strom verhindernde oder hemmende Struktur (39, 120, 220) umfasst, wobei sich die besagte elektrochemische Zelle durch die besagte Struktur erstreckt und **gekennzeichnet dadurch, dass** die besagte Struktur (39, 220) eine epitaktische Schicht umfasst umfassend ein halbleitendes Material, das ein niedrigeres Dotierungsniveau hat als das dotierte halbleitende Material des Trägerelementes, oder ein halbleitendes Material, das Schichten umfasst, die eine Dotierungsart mit entgegengerichteter Polarität haben, sodass sich ein p-n- oder ein n-p-Übergang ausbildet.

2. Die Masterelektrode gemäß Anspruch 1, wobei die besagte Struktur (39, 120, 220) an der Vorderseite (32, 102, 202) des besagten Trägerelementes (31, 101, 201) angeordnet ist und sich in eine Richtung hin zu der Elektrodenoberfläche (33, 103, 203) auf der Rückseite erstreckt, wobei die Dicke der Struktur (39, 120, 220) geringer ist als die Tiefe der zumindest einen elektrochemischen Zelle (34a-d, 104a-d, 204a-d).

3. Die Masterelektrode gemäß Anspruch 1 oder 2, wobei die besagte Struktur (39) eine intrinsische epitaktische Schicht ist.

4. Die Masterelektrode gemäß einem der Ansprüche 1 bis 3, wobei die besagte Struktur (39) eine p-epitaktische Schicht ist.

5. Die Masterelektrode gemäß Anspruch 4, wobei die p-epitaktische Schicht ein Dotierungsniveau in dem Bereich von 10¹³ bis 10¹⁷ Atome/cm³ hat.

6. Die Masterelektrode gemäß einem der Ansprüche 1 bis 5, wobei die besagte Struktur (220) einen bipolaren Transistor umfasst, der zumindest einen p-n-Übergang umfasst.

7. Die Masterelektrode gemäß einem der Ansprüche 1 bis 5, wobei die besagte Struktur (220) einen bipolaren Transistor umfasst, der zumindest einen n-p-Übergang umfasst.

8. Die Masterelektrode gemäß Anspruch 6 oder 7, wobei der besagte bipolare Transistor ein p-n-p-Transistor oder ein n-p-n-Transistor ist.

9. Die Masterelektrode gemäß einem der Ansprüche 1 bis 8, wobei die besagte Struktur (120) eine isolierende Schicht (121) umfasst, derart, dass das besagte Trägerelement (101) ein Silizium-auf-Isolator-Substrat ausbildet.

10. Ein Verfahren zum Bereitstellen einer Masterelektrode zur elektrochemischen Musterreplikation (ECPR) umfassend den Schritt des: Bereitstellens eines Trägerelementes umfassend ein dotiertes halbleitendes Material, Bereitstellens einer elektrisch leitfähigen Elektrodenoberfläche auf einer Rückseite des Trägerelementes und eines topografischen Musters auf einer Vorderseite des Trägerelementes mit einer zumindest teilweise elektrisch isolierenden Oberseite, derart, dass das besagte topografische Muster zumindest eine elektrochemische Zelle ausbildet umfassend einen Boden und zumindest eine Seitenwand, wobei der besagte Boden eine elektrisch leitfähige Oberfläche hat, die leitfähig mit der elektrisch leitfähigen Elektrodenoberfläche auf der Rückseite durch das Trägerelement verbunden ist, wobei das besagte Verfahren weiter den Schritt aufweist des: Bereitstellens einer einen elektrischen Strom verhindernden oder hemmenden Struktur, wobei sich die besagte elektrochemische Zelle durch die besagte Struktur erstreckt, **gekennzeichnet dadurch, dass** die besagte Struktur eine epitaktische Schicht umfasst umfassend ein halbleitendes Material, das ein niedrigeres Dotierungsniveau hat als das dotierte halbleitende Material des Trägerelementes, oder ein halbleitendes Material, das Schichten umfasst, die eine Dotierungsart mit entgegengerichteter Polarität haben, sodass sie einen p-n- oder einen n-p-Übergang ausbilden.

11. Das Verfahren gemäß Anspruch 10, wobei der Schritt des Bereitstellens einer einen elektrischen Strom verhindernden oder hemmenden Struktur zwischen der besagten Vorderseite und der besagten Rückseite des besagten Trägerelementes das Bilden eines bipolaren Transistors auf dem besagten Trägerelement umfasst.

12. Das Verfahren gemäß Anspruch 10, wobei der Schritt des Bereitstellens einer einen elektrischen Strom verhindernden oder hemmenden Struktur zwischen der besagten Vorderseite und der besagten Rückseite des besagten Trägerelementes das Bilden einer Silizium-auf-Isolator-Struktur auf dem besagten Trägerelement umfasst.

## Revendications

1. Électrode maître (30, 100, 200) destinée à une réplication électrochimique de motifs (ECPR), comprenant un élément faisant office de support (31, 101, 201) comprenant une matière semiconductrice dopée, l'électrode maître possédant une surface d'électrode électroconductrice (33, 103, 203) sur un côté arrière et un motif topographique sur un côté avant (32, 102, 202) comprenant un sommet procurant une isolation électrique au moins en partie, ledit motif topographique formant au moins une pile électrochimique (34ad, 104a-d, 204a-d) comprenant une base et au moins une paroi latérale, ladite base possédant une surface électroconductrice reliée par conduction à la surface d'électrode électroconductrice (33, 103, 203) sur le côté arrière à travers l'élément faisant office de support (31, 101, 201) ; dans laquelle ledit élément faisant office de support (31, 101, 201) comprend en outre une structure (39, 120, 220) destinée à empêcher un courant électrique ou à faire obstruction à ce dernier; dans laquelle ladite pile électrochimique s'étend à travers ladite structure, et **caractérisée en ce que** ladite structure (39, 220) comprend une couche épitaxique comprenant un matériau semi-conducteur qui possède un taux de dopage inférieur à celui du matériau semi-conducteur dopé de l'élément faisant office de support ou un matériau semi-conducteur qui comprend des couches possédant un type de dopage à polarité opposée pour ainsi obtenir une jonction p-n ou n-p.

2. Électrode maître selon la revendication 1, dans laquelle ladite structure (39, 120, 220) est disposée sur le côté avant (32, 102, 202) dudit élément faisant office de support (31, 101, 201) et s'étend dans une direction orientée vers la surface d'électrode (33, 103, 203) sur le côté arrière ; dans laquelle l'épaisseur de la structure (39, 120, 220) est inférieure à la profondeur de ladite au moins une pile électrochimique (34a-d, 104a-d, 204a-d).

3. Électrode maître selon la revendication 1 ou 2, dans laquelle ladite structure (39) représente une couche épitaxique intrinsèque.

4. Électrode maître selon l'une quelconque des revendications 1 à 3, dans laquelle ladite structure (39) représente une couche épitaxique de type p.

5. Électrode maître selon la revendication 4, dans laquelle la couche épitaxique de type p possède un taux de dopage dans la plage de 10¹³ à 1017 atomes/cm³.

6. Électrode maître selon l'une quelconque des revendications 1 à 5, dans laquelle ladite structure (220) comprend un transistor bipolaire, comprenant au moins une jonction p-n.

7. Électrode maître selon l'une quelconque des revendications 1 à 5, dans laquelle ladite structure (220) comprend un transistor bipolaire, comprenant au moins une jonction n-p.

8. Électrode maître selon la revendication 6 ou 7, dans laquelle ledit transistor bipolaire est un transistor p-n-p ou un transistor n-p-n.

9. Électrode maître selon l'une quelconque des revendications 1 à 8, dans laquelle ladite structure (120) comprend une couche d'isolation (121) d'une manière telle que ledit élément faisant office de support (101) forme un substrat du type silicium sur isolant.

10. Procédé pour procurer une électrode maître destinée à une réplication électrochimique de motifs (ECPR), comprenant les étapes consistant à :
procurer un élément faisant office de support comprenant un matériau semi-conducteur dopé ;
procurer une surface d'électrode électroconductrice sur un côté arrière de l'élément faisant office de support et un motif topographique sur un côté avant de l'élément faisant office de support, comprenant un sommet procurant une isolation électrique au moins en partie d'une manière telle que ledit motif topographique forme au moins une pile électrochimique comprenant une base et au moins une paroi latérale, ladite base possédant une surface électroconductrice, relié par conduction à la surface d'électrode électroconductrice sur le côté arrière à travers l'élément faisant office de support ;
dans lequel ledit procédé comprend en outre l'étape consistant à :
procurer une structure destinée à empêcher un courant électrique ou à faire obstruction à ce dernier; dans laquelle ladite pile électrochimique s'étend à travers ladite structure, et **caractérisée en ce que** ladite structure ;
**caractérisé en ce que**
ladite structure comprend une couche épitaxique comprenant un matériau semi-conducteur qui possède un taux de dopage inférieur à celui du matériau semi-conducteur dopé de l'élément faisant office de support ou un matériau semi-conducteur qui comprend des couches possédant un type de dopage à polarité opposée pour ainsi obtenir une jonction p-n ou n-p.

11. Procédé selon la revendication 10, dans lequel l'étape consistant à procurer une structure destinée à empêcher un courant électrique ou à faire obstruction à ce dernier entre ledit côté avant et ledit côté arrière dudit élément faisant office de support comprend le montage d'un transistor bipolaire sur ledit élément faisant office de support.

12. Procédé selon la revendication 10, dans lequel l'étape consistant à procurer une structure destinée à empêcher un courant électrique ou à faire obstruction à ce dernier entre ledit côté avant et ledit côté arrière dudit élément faisant office de support comprend le montage d'une structure du type silicium sur isolant, sur ledit élément faisant office de support.
